# EUROPÄISCHE PATENTSCHRIFT

(11) **EP 1 731 008 B1**
(45) Veröffentlichungstag und Bekanntmachung des Hinweises auf die Patenterteilung: **14.05.2008**
(21) Anmeldenummer: 05716850.2
(22) Anmeldetag: 01.03.2005
(51) Int. Cl.: H05K 13/04

(54) **VERFAHREN UND REVOLVERARTIGER BESTÜCKKOPF ZUM BESTÜCKEN VON SUBSTRATEN MIT ELEKTRISCHEN BAUELEMENTEN**
METHOD AND REVOLVER-LIKE EQUIPPING HEAD FOR EQUIPPING SUBSTRATES WITH ELECTRICAL COMPONENTS
PROCEDE ET TETE DE MONTAGE DE TYPE TOURELLE CONCUE POUR MONTER DES COMPOSANTS ELECTRIQUES SUR DES SUBSTRATS

(30) Priorität: 31.03.2004 DE 102004015848
(43) Veröffentlichungstag der Anmeldung: 13.12.2006
(73) Patentinhaber: SIEMENS AKTIENGESELLSCHAFT, 80333 München (DE)
(72) Erfinder: BESCH, Karl-Heinz, 82140 Olching (DE); BLIEM, Thomas, 81379 München (DE); FRIESENHAN, Stefan, 82276 Luttenwang (DE); KNOLL, Hannes, 80339 München (DE); LACHNER, Kurt, 85247 Schwabhausen (DE); ROSSMANN, Thomas, 86919 Utting (DE); SCHMID, Rudolf, 82223 Eichenau (DE); STADLER, Uwe, 81249 München (DE); TRIGIANI, Michele, 81373 München (DE)
(86) Internationale Anmeldenummer: PCT/EP2005/050876
(87) Internationale Veröffentlichungsnummer: WO 2005/096687

(56) Entgegenhaltungen:
- EP-A- 0 315 799
- EP-A- 0 906 011
- WO-A-01/47334
- DE-A1- 10 100 619
- FR-A- 2 661 309

## Beschreibung

Die Erfindung bezieht sich auf ein Verfahren und einen Bestückkopf zum Bestücken von Substraten mit elektrischen Bauelementen mittels einer Bestückvorrichtung, die ein Chassis und einen parallel zum Substrat verschiebbaren revolverartigen Bestückkopf mit einem schrittweise drehbaren Rotor aufweist, der mit umlaufend angeordneten Greifereinheiten mit drehbaren Spindeln zum Halten der Bauelemente versehen ist, wobei der Bestückkopf zumindest einen Drehantrieb für die Spindeln aufweist und wobei die peripher bereitgestellten Bauelemente jeweils in einer Hubposition an die Spindeln angesaugt und auf das Substrat aufgesetzt werden.

Ein derartiges Verfahren ist z.B. durch die WO 2001047334 A bekannt geworden, nach der die Bauelemente von Zuführeinrichtungen abgeholten Bauelemente ungefähr in ihre Aufsetzlage vorgedreht, an einer Abtaststation optisch vermessen und an einer in der Drehrichtung des Rotors nachfolgend angeordneten Drehstation in ihre genaue Bestückstellung verdreht werden. Durch das Vermessen der Bauelemente ist auch möglich, die orthogonalen Lageabweichungen durch Korrektur der entsprechenden Bestückkoordinaten zu kompensieren. Die mit dem Bestückkopf bewegte Abtaststation weist aus Raum- und Gewichtsgründen ein begrenztes Gesichtsfeld auf, so dass große Bauelemente nicht erfaßt werden können. Ferner liegt die Aufsetzfläche von sehr dicken Bauelementen außerhalb der Abtastebene, so dass auch solche Bauelemente nicht bestückt werden können. Sperrige Bauelemente passen ohnehin nicht in die Bauelemente-Umlaufbahn des Bestückkopfes.

Solche Bauelemente werden üblicherweise z.B. durch einen Bestückkopf mit einer feststehenden Greifereinheit gehandhabt und an einer am Chassis verankerten stationären Abtastvorrichtung vermessen, die zwischen den Zuführeinrichtungen und dem Substrat angeordnet ist. Die Dauer eines Bestückzyklus ist entsprechend groß. Die stationäre Abtasteinrichtung unterliegt keinen Gewichts- und Raumbeschränkungen. Sie eignet sich daher auch für Bauelemente, die eine erhöhte Positioniergenauigkeit erfordern.

Der Erfindung liegt die Aufgabe zugrunde, das Spektrum der mit dem revolverartigen Bestückkopf bestückbaren Bauelemente zu vergrößern, um einen zweiten Bestückkopf überflüssig zu machen.

Diese Aufgabe wird durch die Erfindung gemäß den Ansprüchen 1 und 5 gelöst.

Durch das Verfahren nach Anspruch 1 ist es möglich, mit dem revolverartigen Bestückkopf auch Bauelemente zu handhaben, die mit der am Bestückkopf vorhandenen Abtaststation nicht vermessen werden können. Das bedeutet, dass diese Bauelemente, sofern sie in die Umlaufbahn des Bestückkopfes passen, in größere Stückzahl zunächst an den Zuführeinrichtungen für die Bauelemente aufgenommen werden können. Die restlichen Spindeln können mit normal großen Bauelementen belegt werden, die durch die kopfeigene Abtaststation zeitsparend vermessen werden können. Danach verfährt der Bestückkopf über die im Chassis verankerte stationäre Abtasteinrichtung, an der die größeren Bauelemente in schrittweiser Abfolge vermessen werden. Im Anschluss daran können sämtliche am Bestückkopf gehaltenen Bauelemente in einem Drehumlauf auf das Substrat aufgesetzt werden. Das bedeutet, dass für die einzelnen größeren Bauelemente keine zusätzlichen Verfahrbewegungen des Bestückkopfes erforderlich sind, wie dies bei einem Einfachkopf der Fall wäre, auf den nun vollständig verzichtet werden kann.

Nach einer Weiterbildung der Erfindung kann eines der Bauelemente an der Abtasteinrichtung optisch vermessen und ohne weitere Rotordrehung auf das Substrat aufgesetzt werden. Dies setzt voraus, dass der Bestückkopf mit einem Drehantrieb für die in der Aufsetzposition befindliche Spindel ausgestattet ist. Durch den Verzicht auf eine Rotordrehung für dieses eine Bauelement kann eine höhere Positioniergenauigkeit erreicht werden, die für einige Bauelementetypen gefordert sein kann. Diese Vorgehensweise ist auch für übergroße Bauelemente angezeigt, die für die Umlaufbahn im Bestückkopf zu sperrig sind. Es versteht sich, dass hierbei die letzte freie Greifereinheit ein solches Bauteil von der entsprechenden Zuführeinrichtung abholt, über der Abtasteinrichtung vermisst und ohne jede Rotordrehung auf das Substrat aufsetzt, worauf auch die kleineren Bauelemente auf das Substrat aufgesetzt werden können.

Nach einer anderen Weiterbildung der Erfindung werden mehrere der angesaugten Bauelemente in unmittelbarer Folge an der Abtasteinrichtung vermessen und auf das Substrat aufgesetzt. Das bedeutet, dass die Bauelemente, die zwar durch die Umlaufbahn im Bestückkopf hindurchgeführt werden können, die aber für die kopfeigene Abtaststation zu groß sind, gruppenweise von einander benachbarten Greifereinheiten aufgenommen werden können. Dadurch ist es möglich, diese Bauelemente in einer ununterbrochenen Folge zu vermessen und auf das Substrat aufzusetzen. Die restlichen kleineren Bauelemente werden dann sinnvoll ebenfalls in einer zusammenhängenden Folge von benachbarten Greifereinheiten aufgenommen, im Bestückkopf gemäß Anspruch 4 vermessen und in ununterbrochener Folge auf das Substrat aufgesetzt.

Eine Einrichtung zur Positionierung einer Bauelementeaufnahmeeinheit eines Bestückautomaten für Leiterplatten, wobei zur individuellen Drehpositionierung einer Saugpipette um ihre eigene Achse eine Inkrementalgeberanordnung vorgesehen ist, ist aus DE 101 00 619 A bekannt.

Durch die Erfindung gemäß Anspruch 5 ist es möglich, die Bauelementedrehung während des Rotorumlaufes nach dem Vermessen der kleineren Bauelemente an der kopfeigenen Abtaststation durchzuführen. Das an der stationären Abtasteinrichtung vermessene letzte Bauelement kann in dieser Rotorstellung verbleiben und durch den zugehörigen Drehantrieb in die geforderte Aufsetzstellung mit hoher Genauigkeit verdreht werden.

Durch die Verdrehbarkeit des Rotors nach Anspruch 6 in beiden Drehrichtungen ist es zum Beispiel möglich, die zuletzt aufgenommenen größeren Bauelemente in umgekehrter Drehrichtung über der stationären Abtasteinrichtung in ununterbrochener Folge zeitsparend zu positionieren. Durch die freie Wählbarkeit der Drehrichtung ist es möglich, unter Beibehaltung dieser Drehrichtung zuerst die kleineren Bauelemente abzusetzen oder unter erneut gewechselter Drehrichtung zuerst die größeren Bauelemente zu bestücken.

Im Folgenden wird die Erfindung anhand eines in der Zeichnung dargestellten Ausführungsbeispieles näher erläutert. Es zeigen schematisiert:
- Figur 1: eine Stirnansicht eines revolverartigen Bestückkopfes mit elektrischen Bauelementen über einer Zuführeinrichtung für die Bauelemente,
- Figur 2: eine Seitenansicht des Bestückkopfes nach Figur 1,
- Figur 3: den Bestückkopf nach Figur 1 über einer anderen Zuführeinrichtung,
- Figur 4: den Bestückkopf nach Figur 3 in einer anderen Ablaufphase,
- Figur 5: den Bestückkopf nach Figur 1 über einer stationären optischen Abtasteinrichtung,
- Figur 6: den Bestückkopf nach Figur 5 in einer nachfolgenden Ablaufphase,
- Figur 7: den Bestückkopf nach Figur 1 mit einem Substrat,
- Figur 8: den Bestückkopf nach Figur 7 in einer weiteren Ablaufphase.

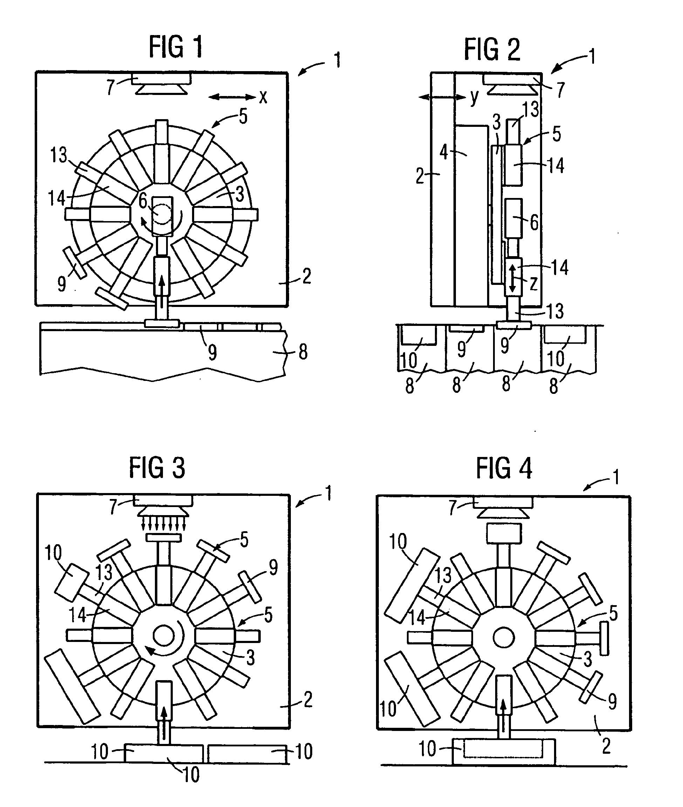

Nach den Figuren 1 und 2 ist ein revolverartiger Bestückkopf 1 mittels einer nicht näher dargestellten Positioniereinrichtung einer Bestückvorrichtung in zwei waagerechten Koordinatenrichtungen X und Y verschiebbar. Der Bestückkopf 1 weist einen Stator 2 und einen Rotor 3 auf, der mittels eines Motors 4 in festen Winkelschritten verdrehbar ist. Der Rotor ist mit sternförmig um seine Drehachse umlaufend angeordneten Greifereinheiten 5 versehen, die schrittweise zu einer unteren Hubstation 6 bzw. zu einer diametral gegenüberliegenden, am Stator 2 befestigten oberen optischen Abtaststation 7 verdreht werden können, wobei die Hubstation 6 eine Hubposition der radial orientierten Greifereinheiten 5 definiert.

Der Bestückkopf 1 befindet sich hier über einer Zuführeinrichtung 8 für elektrische Bauelemente 9 in einem peripheren Bereich der Bestückvorrichtung. Dabei befindet sich die untere Greifereinheit 5 unmittelbar über einem abzuholenden kleineren Bauelement 9 und wurde durch die Hubstation 6 in einer senkrechten Koordinatenrichtung z soweit nach unten geschoben, dass sie das Bauelement 9 durch Ansaugen erfassen und bereits teilweise aus der Zuführeinrichtung 8 herausheben konnte. In gleicher Weise sind bereits zwei vorangehende Greifereinheiten 5 mit den Bauelementen 9 belegt. Größere Bauelemente 10 sind in benachbarten Zuführeinrichtungen 8 bereitgestellt. Die Bauelemente 9 von kleinerer Bauart können problemlos an der Abtaststation 7 vermessen werden. Die Greifereinheit 5 weist eine Spindel 13 und einen Drehantrieb 14 zum definierten Drehen der Spindel 13 um ihre Längsachse auf, wobei die äußere Stirnfläche der Spindel 13 mit einer nicht dargestellten Ansaugöffnung für die Bauelemente 9 und 10 versehen ist

Nach den Figuren 3 und 4 können zwar die größeren Bauelemente 10 noch durch den Bestückkopf hindurch transportiert werden, sie sind jedoch für die Abtaststation 7 zu dick oder zu lang. Zwischen zwei der größeren Bauelemente 10 bleibt jeweils eine der Greifereinheiten von Bauelementen frei, um eine gegenseitige Kollision zu vermeiden. Die in unmittelbarer aufeinanderfolgend aufgenommenen kleineren Bauelemente 9 können bereits synchron mit dem Abholen der größeren Bauelemente 10 an der Abtaststation 7 vermessen werden.

Figur 4 zeigt den Bestückkopf 1 am Ende der Bauelementeaufnahme. An Stelle eines der strichpunktiert angedeuteten großen Bauelementes 10 kann hier auch ein übergroßes Bauelement 10 aufgenommen werden, das nicht mehr durch den Bestückkopf 1 hindurchpasst.

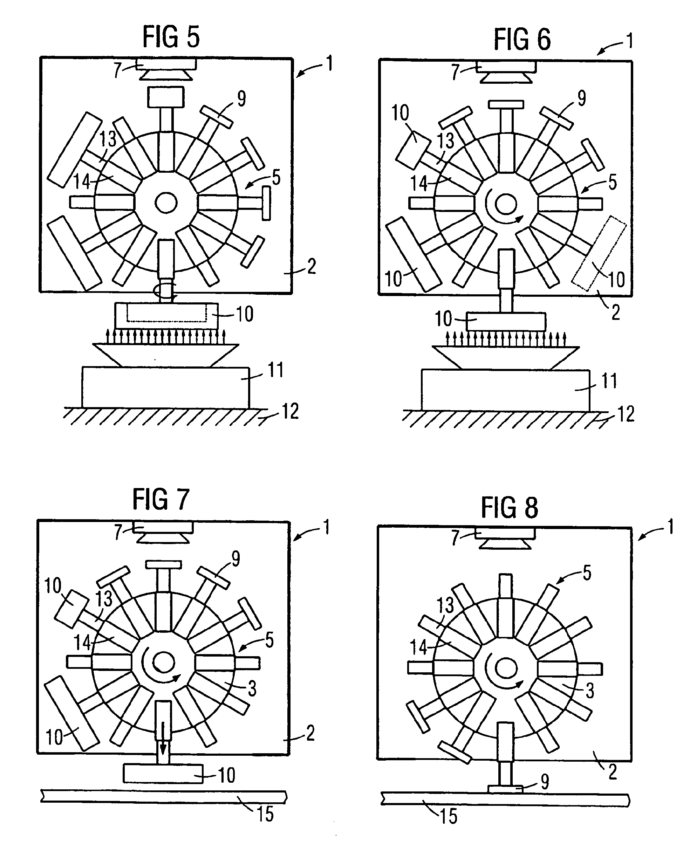

Anschließend wird der Bestückkopf 1 nach Figur 5 über eine stationäre optische Abtasteinrichtung 11 verfahren, die an einem Chassis 12 der Bestückvorrichtung verankert ist. Nach dem Abholen des zuletzt aufgenommenen Bauelements 10 ist der Rotor 3 nicht weiter verdreht worden, so dass nun dieses Bauelement zuerst durch die Abtasteinrichtung 11 vermessen werden kann. Durch den der Greifereinheit 5 zugeordneten Drehantrieb 14 ist es möglich, die mit dem übergroßen Bauelement 10 belegte Spindel 13 soweit zu verdrehen, dass das Bauelement 10 in die geforderte Aufsetzlage verdreht und unmittelbar darauf auf ein Substrat 15 (Figur 7) aufgesetzt werden kann. Das strichpunktiert angedeutete weniger großen Bauelement 10 braucht dieses nicht sofort auf die Leiterplatte aufgesetzt werden, sondern kann zunächst an seiner Greifereinheit 5 verbleiben.

Nach Figur 6 ist der Bestückkopf nach dem Aufsetzen des übergroßen Bauelementes 10 auf das Substrat 15 (Figur 7) zur Abtasteinrichtung 11 zurückgekehrt, um unter Rückdrehung des Rotors 3 sukzessive die übrigen der großen Bauelemente 10 zu vermessen, die anschließend mittels der einzelnen Drehantriebe 14 in ihre Aufsetzlage verdreht werden können.

Nach Figur 7 und 8 können zunächst die größeren Bauelemente 10 danach die kleineren Baulemente 9 auf ein Substrat 15 in unmittelbarer Folge aufgesetzt werden womit der Bestückzyklus beendet ist.

Es ist auch möglich, den Zyklus mit einer anderen Reihenfolge zu betreiben. Beispielsweise können die großen Bauelemente 10 bereits vor dem Abholen des übergroßen Bauelementes 10 vermessen werden, so dass das Substrat 15 in einem Umlauf des Rotors 3 ohne Unterbrechung bestückt werden kann. Durch die Möglichkeit der Vorwärts- und Rückwärtsdrehung des Rotors 3 kann je nach der Art und der Anzahl der Bauelemente 9, 10 ein abweichender zeitoptimierter Modus gewählt werden.

### Bezugszeichen

- 1: Bestückkopf
- 2: Stator
- 3: Rotor
- 4: Motor
- 5: Greifereinheit
- 6: Hubstation
- 7: Abtaststation
- 8: Zuführeinheit
- 9: Bauelement
- 10: Bauelement
- 11: Abtasteinrichtung
- 12: Chassis
- 13: Spindel
- 14: Drehantrieb
- 15: Substrat

## Patentansprüche

1. Verfahren zum Bestücken von Substraten (15) mit elektrischen Bauelementen (9, 10) in einer Bestückvorrichtung, die ein Chassis (12) und einen parallel zum Substrat (15) verschiebbaren revolverartigen Bestückkopf (1) mit einem schrittweise drehbaren Rotor (3) aufweist, der mit umlaufend angeordneten Greifereinheiten (5) mit drehbaren Spindeln (13) zum Halten der Bauelemente (9, 10) versehen ist,
wobei der Bestückkopf (1) zumindest einen Drehantrieb (14) für die Spindeln (13) aufweist und
wobei die peripher bereitgestellten Bauelemente (9, 10) jeweils in einer Hubposition an die Spindeln (13) angesaugt, optisch abgetastet und auf das Substrat (15) aufgesetzt werden,
**daduch gekennzeichnet,** dass zumindest eines der angesaugten Bauelemente (10) in der Hubposition über eine am Chassis (12) verankerte optische Abtasteinrichtung (11) verfahren wird und
dass die Spindel (13) mit dem Bauelement (10) durch den Drehantrieb (14) in eine vorgegebene Winkellage verdreht und auf das Substrat (15) aufgesetzt wird.

2. Verfahren nach Anspruch 1,
**dadurch gekennzeichnet, dass** eines der Bauelemente (10) an der Abtasteinrichtung (11) optisch vermessen und ohne weitere Rotordrehung auf das Substrat (15) aufgesetzt wird.

3. Verfahren nach Anspruch 1 oder 2,
**dadurch gekennzeichnet, dass** mehrere der angesaugten Bauelemente (10) in unmittelbarer Folge an der Abtasteinrichtung (11) vermessen und auf das Substrat (15) aufgesetzt werden.

4. Verfahren nach Anspruch 1, 2 oder 3,
**dadurch gekennzeichnet, dass** die Bauelemente (9) in einer optischen Abtaststation (7) des Bestückkopfs (1) vermessen werden.

5. Revolverartiger Bestückkopf (1) mit einer Mehrzahl von an einem Rotor (3) gelagerten Greifereinheiten (5) zum Ansaugen von auf ein Substrat (15) aufzusetzenden elektrischen Bauelementen (9, 10),
wobei der schrittweise drehbare Rotor (3) zumindest in einer zum Substrat (15) parallelen Koordinatenrichtung verschiebbar ist,
wobei die Greifereinheit (5) eine um eine Achse drehbare Spindel (13) aufweist, an der das Bauelement (9, 10) fixierbar ist, nach einem der vorhergehenden Ansprüche und wobei der Bestückkopf (1) zumindest einen Drehantrieb (14) für die Spindeln (13) aufweist,
**dadurch gekennzeichnet, dass** jede der Greifereinheiten (5) einen Drehantrieb (14) für die zugehörige Spindel (13) aufweist.

6. Bestückkopf (1) nach Anspruch 5,
**dadurch gekennzeichnet,**
**dass** der Rotor (3) in entgegengesetzten Drehrichtungen antreibbar ist.

## Claims

1. Method for equipping substrates (15) with electrical components (9, 10) in an equipping device which comprises a chassis (12) and a revolver-like equipping head (1) displaceable parallel to the substrate (15) and with a progressively rotatable rotor (3) which is provided with circumferentially arranged gripper units (5) with rotatable spindles (13) for holding the components (9, 10), the equipping head (1) comprising at least one rotary drive (14) for the spindles (13) and the peripherally provided components (9, 10) in each case being drawn by suction in a lifting position onto the spindles (13), optically scanned and placed onto the substrate (15), **characterised in that** at least one of the suctioned components (10) is moved in the lifting position via an optical scanning device (11) anchored to the chassis (12), and **in that** the spindle (13) is rotated with the component (10) by the rotary drive (14) into a predetermined angular position and placed onto the substrate (15).

2. Method according to claim 1, **characterised in that** one of the components (10) is optically measured at the scanning device (11) and placed onto the substrate (15) without further rotation of the rotor.

3. Method according to claim 1 or 2, **characterised in that** a plurality of suctioned components (10) are measured in direct succession at the scanning device (11) and placed onto the substrate (15).

4. Method according to claim 1, 2 or 3, **characterised in that** the components (9) are measured in an optical scanning station (7) of the equipping head (1).

5. Revolver-like equipping head (1) comprising a plurality of gripper units (5), mounted on a rotor (3), for drawing by suction electrical components (9, 10) that are to be placed on a substrate (15), the progressively rotatable rotor (3) being displaceable at least in one coordinate direction parallel to the substrate (15), the gripper unit (5) comprising a spindle (13) that is rotatable about an axle and to which the component (9, 10) can be fixed, according to any one of the preceding claims, and the equipping head (1) comprising at least one rotary drive (4) for the spindles (13), **characterised in that** each of the gripper units (5) comprises a rotary drive (14) for the associated spindle (13).

6. Equipping head (1) according to claim 5, **characterised in that** the rotor (3) can be driven in opposing directions of rotation.

## Revendications

1. Procédé pour munir des substrats (15) de composants électriques (9, 10) dans un dispositif de montage qui présente un châssis (12) et une tête de montage (1) de type revolver déplaçable parallèlement au substrat (15) et comprenant un rotor (3) qui peut tourner par étapes et qui est muni d'unités de préhension (5) agencées sur la périphérie et comportant des broches rotatives (13) afin de maintenir les composants (9, 10),
dans lequel la tête de montage (1) présente au moins un entraînement rotatif (14) pour les broches (13) et
dans lequel les composants (9, 10) mis à disposition sur la périphérie sont aspirés respectivement dans une position de levage sur les broches (13), explorés optiquement et sont posés sur le substrat (15),
**caractérisée en ce qu'**au moins un des composants aspirés (10) est déplacé dans la position de levage au-dessus d'un dispositif d'exploration optique (11) ancré sur le châssis (12) et
**en ce que** la broche (13) est tournée avec le composant (10) par l'entraînement rotatif (14) jusque dans une position angulaire prescrite et est posée sur le substrat (15).

2. Procédé selon la revendication 1,
**caractérisé en ce que** l'un des composants (10) est mesuré optiquement sur le dispositif d'exploration (11) et est posé sur le substrat (15) sans autre rotation du rotor.

3. Procédé selon la revendications 1 ou 2,
**caractérisé en ce que** plusieurs des composants aspirés (10) sont mesurés selon une séquence directe sur le dispositif d'exploration (11) et sont posés sur le substrat (15).

4. Procédé selon la revendications 1, 2 ou 3,
**caractérisé en ce que** les composants (9) sont mesurés dans une station d'exploration optique (7) de la tête de montage (1).

5. Tête de montage (1) de type revolver, comprenant une pluralité d'unités de préhension (5) montées sur un rotor (3) pour aspirer des composants électriques (9, 10) devant être posés sur un substrat (15),
dans laquelle le rotor pouvant tourner par étapes (3) peut être déplacé au moins dans une direction de coordonnées parallèle au substrat (15),
dans laquelle l'unité de préhension (5) présente une broche (13) qui peut tourner autour d'un axe, sur laquelle le composant (9, 10) peut être fixé, selon l'une des revendications précédentes, et
dans laquelle la tête de montage (1) présente au moins un entraînement rotatif (14) pour les broches (13),
**caractérisée en ce que** chacune des unités de préhension (5) présente un entraînement rotatif (14) pour la broche correspondante (13).

6. Tête de montage (1) selon la revendication 5,
**caractérisée en ce que**
le rotor (3) peut être entraîné dans des sens de rotation opposés.
